# EUROPÄISCHE PATENTSCHRIFT

(11) **EP 2 248 139 B1**
(45) Veröffentlichungstag und Bekanntmachung des Hinweises auf die Patenterteilung: **18.10.2017**
(21) Anmeldenummer: 09714320.0
(22) Anmeldetag: 24.02.2009
(51) Int. Cl.: G01R 31/333, H01F 27/34, H01F 27/36, H01F 27/38, H01F 37/00

(54) **DROSSELANORDNUNG MIT EINER EINE ERSTE UND EINE ZWEITE TEILWICKLUNG AUFWEISENDEN SPULE**
CHOKE ARRANGEMENT WITH A FIRST AND A SECOND PARTIAL COIL COMPRISING A PARTIAL WINDING
SYSTÈME D'ÉTRANGLEMENT PRÉSENTANT UNE BOBINE COMPRENANT UN PREMIER ENROULEMENT PARTIEL ET UN SECOND ENROULEMENT PARTIEL

(30) Priorität: 27.02.2008 DE 102008011802
(43) Veröffentlichungstag der Anmeldung: 10.11.2010
(73) Patentinhaber: Siemens Aktiengesellschaft, 80333 München (DE)
(72) Erfinder: GAHN, Stephan, 95233 Helmbrechts (DE); PRUCKER, Udo, 90571 Schwaig (DE)
(86) Internationale Anmeldenummer: PCT/EP2009/052137
(87) Internationale Veröffentlichungsnummer: WO 2009/106511

(56) Entgegenhaltungen:
- DE-U1- 29 620 134
- GB-A- 983 481
- US-A- 4 473 811

## Beschreibung

Die Erfindung bezieht sich auf eine Drosselanordnung mit einer eine erste und eine zweite Teilwicklung aufweisenden Spule, wobei die Teilwicklungen sich jeweils um eine Wickelachse herum erstrecken.

Eine derartige Drosselanordnung ist beispielsweise aus dem Gebrauchsmuster DE 296 201 34 U1 bekannt. Dort ist eine Drosselanordnung beschrieben, die eine Spule mit einer ersten und einer zweiten Teilwicklung aufweist. Die Teilwicklungen erstrecken sich jeweils um eine Wickelachse herum. Derartige Drosselanordnungen werden beispielsweise in Serienresonanzanlagen zur Prüfung von elektrischen Schaltanlagen eingesetzt. Durch die Dimension einer Schaltanlage wird eine Prüflast bestimmt. In Abhängigkeit der Prüflast fließt bei einer Prüfung durch die Spule ein Prüfstrom, welcher um die Spule ein magnetisches Feld entstehen lässt. Die Stärke des Magnetfeldes ist dabei proportional zum Betrag des Stromflusses durch die Spule.

In der Offenlegungsschrift GB 983 481 A wird eine Drossel mit zwei Spulen beschrieben. Die beiden Spulen weisen einen gegenläufigen Wickelsinn auf und sind in Parallelschaltung elektrisch verbunden. Die beiden Spulen sind von einem magnetischen Joch umgeben, das magnetische Streuflüsse an den Stirnseiten der Spulen reduzieren soll.

In der Offenlegungsschrift US 4 473 811 A wird ein als Signalwandler dienender Transformator mit zwei Wicklungen, einer Primärwicklung und einer Sekundärwicklung, beschrieben. Beide Wicklungen bestehen aus zwei gegensinnig gewickelten Teilwicklungen. Der erste Teil dieser Teilwicklungen bestimmt die Induktivität des Signalwandlers, der zweite Teil der Teilwicklungen dient der Entkopplung der beiden Wicklungen. Beide Wicklungen werden in einem Verfahren gemeinsam auf einen Spulenträger aufgebracht.

Mit zunehmender Größe der Prüflast werden Drosselanordnungen verlangt, welche mit vergleichsweise großen Strömen beaufschlagbar sind. Daraus folgend kommt es im Umfeld der Drosselanordnung zum Entstehen von vergrößerten magnetischen Feldern. Hohe magnetische Felder können Störungen hervorrufen. Beispielsweise können in benachbarten elektrisch leitfähigen Teilen Wirbelströme induziert werden, welche zu Wirkleistungsverlusten führen.

Daher ist es Aufgabe der Erfindung, eine Drosselanordnung anzugeben, welche die Gefahr eines Entstehens von Wirkleistungsverlusten reduziert.

Erfindungsgemäß wird dies bei einer Drosselanordnung, wie im Anspruch 1 definiert, gelöst. Um an einer Spule ein magnetisches Wechselfeld erzeugen zu können, wird die Spule von einem Wechselstrom durchflossen. Dieser Wechselstrom ist von einer entsprechenden Wechselspannung getrieben. Ein Stromfluss kann dabei von einem erhöhten Spannungspotential getrieben, über die Spule gegen ein Erdpotential erfolgen. Dabei kann vorgesehen sein, dass zur Erzeugung eines resonant betriebenen Schwingkreises eine Kondensatoranordnung in einen Strompfad eingeschleift wird. Als Kondensatoranordnung kann beispielsweise eine elektrische Schaltanlage dienen. Eine Induktivität der Spule und eine Kapazität der Schaltanlage bilden einen Serienschwingkreis. Die Güte Q des Schwingkreises wird durch im Schwingkreis auftretende Wirkleistungsverluste bestimmt. Durch die gegensinnige Wicklung der Teilwicklungen können die Wirkleistungsverluste der Drosselanordnung verringert werden. Mit verringerten Wirkleistungsverlusten kann die zur Anregung des Schwingkreises nötige Energie reduziert werden. So können beispielsweise leistungsreduzierte Erregertransformatoren zum Betrieb des Schwingkreises eingesetzt werden.

Je nach Ausdehnung der Schaltanlage stellt diese einen Kondensator mit einer mehr oder weniger großen Kapazität dar. Mit zunehmenden Dimensionen einer Schaltanlage nimmt auch deren Kapazität zu. Entsprechend ist zur Erzeugung eines resonant betriebenen Schwingkreises die Induktivität der Spule anzupassen. Um bei einer vorgegebenen Frequenz eine bestimmte Induktivität zur Verfügung zu stellen, ist es notwendig, eine bestimmte Anzahl von Windungen zu verwenden. Zur Erzeugung einer Spule wird beispielsweise ein elektrischer Leiter um eine Wickelachse herum gewunden. Dabei kann der elektrische Leiter in verschiedenartigen Formen gewunden werden. So ist es beispielsweise möglich, eine schraubenförmige Windung des Drahtes oder eine spiralförmige Windung des Drahtes zur Ausbildung einer Spule vorzusehen. Es ist auch möglich, Kombinationen aus schraubenförmiger Windung und spiralförmiger Windung vorzusehen, indem man beispielsweise Windungen axial nebeneinander sowie mehrere Lagen radial übereinander anordnet, so dass eine Spule mit im Wesentlichen hohlzylindrischer Kontur entsteht. Die einzelnen Windungen sind untereinander elektrisch isoliert.

Durch eine Aufteilung einer Spule in eine erste und in eine zweite Teilwicklung, die sich jeweils um eine Wickelachse erstrecken, kann bei einer großen Anzahl von Windungen der Umfang der Spule gegenüber einem herkömmlichen Spulenwickelreduziert werden. Die Drosselanordnung ist vorteilhafterweise mit einer "Luftspule" auszurüsten, dass heißt es wird auf einen magnetfeldleitenden Kern verzichtet.

Durch eine Wicklung der ersten Teilwicklung mit einem ersten Wickelsinn und eine Wicklung der zweiten Wicklung mit einem zweiten Wickelsinn entsteht eine Spule mit unterschiedlichen Abschnitten, die unterschiedliche Wickelsinne aufweisen. Der Wickelsinn ist jeweils auf die Wickelachse bezogen. So kann man einen elektrischen Leiter beispielsweise mit dem Uhrzeigersinn um eine Wickelachse herum wickeln, oder auch entgegen dem Uhrzeigersinn, um eine Wickelachse herum wickeln. Vorteilhaft kann vorgesehen sein, dass die beiden Teilwicklungen in etwa dieselbe Anzahl von Windungen aufweisen. Dadurch ist es möglich, die Spannungsbelastung an den Teilwicklungen selbst zu vermindern. Es kann vorgesehen sein, dass eine Wicklung sich jeweils von einem Wickeldorn ausgehend radial nach außen erweitert und die Teilwicklungen eine gemeinsame Wickelachse aufweisen, wobei die Wicklungen axial versetzt sind. Um die beiden Teilwicklungen zu einer gemeinsamen Spule elektrisch zu verschalten, ist es vorteilhaft, die Wickelenden, welche sich am äußeren Umfang der Teilwicklungen befinden, miteinander elektrisch zu kontaktieren. Somit ist es möglich, dass ein Spannungsfall, welcher sich über der gesamten Spule abfällt, zu einem ersten Anteil über der ersten Teilwicklung und zu einem zweiten Anteil über der zweiten Teilwicklung abfällt. Damit fällt über jeder der Teilwicklungen nur ein Teil des Spannungsfalls ab, welcher sich über der gesamten Spule erstreckt. Damit ist die Isolation der beiden Teilwicklungen nur auf den jeweiligen Teilspannungsfall über der jeweiligen Teilwicklung auszulegen. Besonders vorteilhaft ist es, wenn die beiden Teilwicklungen in etwa dieselbe Anzahl von Windungen aufweisen. In diesem Falle fällt über jeder der Teilwicklungen etwa der gleiche Spannungsfall an, und zwar jeweils der halbe Spannungsabfall, welcher über der Spule zu halten ist. Gegenüber einer Spule mit einer einzelnen Wicklung bei gleicher Windungszahl kann so die elektrische Isolationsfestigkeit reduziert ausgelegt werden. Des Weiteren ist die radiale Ausdehnung der Teilwicklungen geringer als bei einer Spule mit einer einzigen Wickelkörper.

Vorteilhafterweise kann vorgesehen sein, dass die erste und die zweite Teilwicklung sich um dieselbe Wickelachse erstrecken.

Ein axialer Versatz der beiden Teilwicklungen ermöglicht es, an den beiden Teilwicklungen entstehende Magnetfelder vorteilhaft überlagern zu lassen. Da die beiden Teilwicklungen jeweils mit einem unterschiedlichen Wickelsinn gewickelt wurden und diese Teilwicklungen von ein und demselben Strom durchflossen sind, ergeben sich magnetische Felder im Umfeld der beiden Teilwicklungen, die sich überlagern und teilweise auslöschen bzw. verringern und sich zu einem resultierenden Magnetfeld im Außenraum der Drosselanordnung vereinigen. Somit ist es möglich, den Stromfluss durch die Spule hindurch zu erhöhen bzw. auch deren Induktivität gegebenenfalls zu verstärken, dabei jedoch die Außenwirkung des resultierenden Magnetfeldes gegenüber herkömmlichen Ausgestaltungen der Spule zu reduzieren. Damit ist die Gefahr eines Auftretens von Wirkverlusten, welche durch das resultierende Magnetfeld in elektrisch leitfähigen Teilen hervorgerufen werden können verringert. Sofern Wirkverluste auftreten, sind diese zumindest begrenzt.. Es ist vorgesehen, dass zumindest eine der Teilwicklungen einen Schirmkörper aufweist, welcher einen elektrisch isolierenden Tragkörper aufweist, der eine elektrisch leitende Schicht positioniert. Durch den Einsatz von Schirmkörpern kann eine zusätzliche Beeinflussung des die Spulen umgebenden elektrischen Feldes bzw. Magnetfeldes erfolgen. Durch die Schirmung wird ein beliebiges Austreten der Felder, welche von den Teilwicklungen der Spule erzeugt werden, verhindert. Eine Konstruktion der Schirme unter Nutzung eines elektrisch isolierenden Tragkörpers und einer auf diesem positionierten elektrischen leitenden Schicht hat den Vorteil, dass die mechanische Wirkung des Schirmkörpers von einer elektrischen Wirkung entkoppelt ist.

Eine Anfälligkeit der elektrisch leitenden Schicht gegenüber Wirkverlusten (Wirbelströme) kann durch eine dünne Gestaltung der Schicht reduziert werden. So ist es beispielsweise möglich, relativ massive Tragkörper, beispielsweise aus einem Kunststoff, einem Harz o. ä. zu fertigen und auf diese eine elektrisch leitende Schicht aufzubringen. Die elektrisch leitende Schicht übernimmt die Lenkung und Beeinflussung von Feldern. Da die elektrisch leitende Schicht durch den Tragkörper von mechanischen Kräften frei gehalten wird, kann die elektrische Schicht entsprechend dünn ausgestaltet werden. Beispielsweise kann vorgesehen sein, dass der elektrisch isolierende Tragkörper durch eine Lackierung oder anderweitig geeignete Verfahren wie z. B. galvanischem Bedämpfen usw. mit der elektrisch leitenden Schicht versehen ist. Die elektrisch leitende Schicht weist gegenüber dem Tragkörper nur eine geringe mechanische Widerstandsfähigkeit auf.

Weiterhin kann vorteilhaft vorgesehen sein, dass die elektrisch leitende Schicht auf dem Tragkörper ringförmig umläuft, wobei eine Unterbrechungsstelle einen geschlossenen Umlauf unterbricht.

Durch einen Umlauf der elektrisch leitenden Schicht um die Wickelachse zumindest einer der Teilwicklungen ist eine möglichst allseitige Schirmwirkung in radialen Richtungen gewährleistet. Aufgrund der oben stehend beschriebenen hohen Magnetfelder besteht jedoch die Gefahr der Induktion von Wirbelströmen in der elektrisch leitenden Schicht. Durch eine Unterbrechungsstelle in der elektrisch leitenden Schicht wird ein geschlossener Umlauf verhindert. Dadurch ist eine offene Ringstruktur in der elektrisch leitenden Schicht geschaffen, so dass ein Auftreten von induzierten Kreisströmen in der elektrisch leitfähigen Schicht erschwert ist. Die Unterbrechungsstelle kann beispielsweise durch das Vorsehen einer galvanischen Unterbrechung der elektrisch leitenden Schicht an dem Tragkörper erfolgen.

Neben einer Anordnung von Schirmkörpern an einem äußeren Umfang der Teilwicklungen können diese beispielsweise auch in inneren Bereichen der Teilwicklungen angeordnet sein.

Vorteilhafterweise kann vorgesehen sein, dass die Spule von einem metallischen Gehäuse umgeben ist.

Der Einsatz eines metallischen Gehäuses, vorzugsweise eines im Wesentlichen nach Art eines Rohres strukturierten Gehäuses, gestattet einen mechanischen Schutz, der im Innern befindlichen Spule. Dabei kann vorgesehen sein, dass das Gehäuse die Spule in radialer Richtung vollständig umgibt. Dadurch ist ein Einwirken von äußeren Kräften auf die Spule vermieden. Des Weiteren kann vorgesehen sein, dass das Gehäuse fluiddicht ausgeführt ist, so dass das Innere des Gehäuses beispielsweise mit einem Medium wie einem Fluid, beispielsweise einem Isoliergas oder einer Isolierflüssigkeit befüllt werden kann. Damit kann die elektrische Festigkeit der die Spule unmittelbar umgebenden Bereiche positiv beeinflusst werden. Bei der Verwendung eines Isoliergases, beispielsweise Schwefelhexafluorid, Stickstoff oder anderer geeigneter Gase sowie Gasgemische ist es vorteilhaft, dieses Isoliergas mit einem gegenüber der Umgebung erhöhten Druck zu beaufschlagen. Dadurch wird die Isolationsfestigkeit des Isoliergases zusätzlich erhöht.

Als Isolierflüssigkeit können beispielsweise Isolieröle oder andere Stoffe zum Einsatz kommen.

Durch die Wandungen des Gehäuses hindurch können elektrische Leiter isoliert hindurchgeführt werden. Dazu können entsprechende Scheibenisolatoren, Durchführungen etc. an Öffnungen des Gehäuses angeordnet werden.

Die Verwendung eines metallischen Gehäuses ermöglicht die Bereitstellung einer mechanisch widerstandsfähigen Baugruppe, welche ein Chassis für in ihrem Inneren angeordnete Elemente bilden kann.

Als Metalle zur Ausbildung des Gehäuses sind ferromagnetische Metalle sowie nichtferromagnetische Metalle geeignet. Als nichtferromagnetische Metalle eignen sich besonders Aluminiumverbindungen sowie Legierungen rostfreier Stähle.

Die Verwendung von Aluminiumlegierungen weist den Vorteil auf, dass Gehäuse beispielsweise durch Gussverfahren herstellbar sind. Weiterhin können Aluminiumlegierungen aufgrund ihrer geringen Dichte mit einer größeren Wandstärke versehen sein, ohne die Masse des Gehäuses übermäßig zu erhöhen. Trotz einer zumindest teilweisen Kompensation der von den beiden Teilwicklungen ausgehenden Magnetfelder kann ein verbleibendes Restmagnetfeld in dem Gehäuse Wirbelströme induzieren. Bei einer entsprechenden Wandstärke der Gehäusewandungen können die Ströme sich in einem vergrößerten Volumenbereich erstrecken, wodurch eine durch die Ströme hervorgerufene Erwärmung besser beherrschbar ist.

Zur Ausgestaltung des metallischen Gehäuses kann vorgesehen sein, dass sich das Gehäuse im Wesentlichen koaxial zu einer Wickelachse einer Teilwicklung erstreckt. So ist es beispielsweise möglich, dass metallische Gehäuse rotationssymmetrisch auszugestalten, wobei endseitig entsprechende Flansche vorgesehen sind, die durch Isolatoren verschließbar sind. Die Isolatoren sind dann jeweils von einem elektrischen Leiterzug durchsetzbar, der isoliert gegenüber dem metallischen Gehäuse gehalten sind. Dadurch entsteht eine Gehäusekonstruktion, die von ihren Stirnseiten jeweils Zugangsmöglichkeiten zu der Spule gewährt. Dies ist bei einer Montage einer Drosselanordnung von Vorteil, um beispielsweise eine Trageinrichtung einzubringen, auf welcher die Teilwicklungen aufsitzen. Als Trageinrichtungen eignen sich beispielsweise elektrisch isolierende rohrförmige Anordnungen. Diese können beispielsweise aus einem keramischen Werkstoff gefertigt sein, es können auch Faserverbundwerkstoffe oder Giesharze zum Einsatz gelangen. Dabei ist es vorteilhaft, wenn die Trageinrichtung ebenfalls eine rotationssymmetrische Struktur aufweist, welche koaxial zu einer Wickelachse einer Teilwicklung ausgerichtet ist, wobei eine Teilwicklung oder mehrere Teilwicklungen auf dem Tragelement aufsitzen.

Das Tragelement kann dann beispielsweise an einem stirnseitig vorgesehenen Isolator abgestützt sein.

Eine weitere vorteilhafte Ausgestaltung kann vorsehen, dass die Spule eine dritte und vierte Teilwicklung aufweist, wobei eine erste Gruppe von Teilwicklungen den ersten Wickelsinn und eine zweite Gruppe von Teilwicklungen den zweiten Wickelsinn aufweisen.

Durch das Vorsehen einer dritten und vierten Teilwicklung ist es möglich eine Vergrößerung der Induktivität der Spule zu erreichen und dabei eine azimutal zu einer Wickelachse umlaufende Kontur beizubehalten und lediglich eine axiale Verlängerung der Drosselanordnung vorzusehen. Durch das Vorsehen von vier Teilwicklungen ist es möglich, die Anzahl von Windungen der Spule zu erhöhen und die Induktivität der Anordnung zusätzlich zu vergrößern.

Teilwicklungen können beispielsweise im Wesentlichen hohlzylindrisch ausgeführt sein. Dazu eignen sich so genannte Scheibenwicklungen, d. h., die Höhe eines Hohlzylinders ist im Vergleich zu seinem äußeren Durchmesser kleiner. Von einem idealen Hohlzylinder mit stirnseitig angeordneten kreisscheibenartigen Strukturen kann abgewichen werden. Beispielsweise können die hohlzylindrischen Anordnungen an ihren Stirnseiten mit konischen oder kegelartigen Anformungen versehen werden, so dass diskusartige Teilwicklungen gebildet sind, die an ihrem äußeren Umfang mit entsprechenden Schirmen, gebildet aus einem elektrisch isolierenden Tragkörper mit einer elektrisch leitenden Beschichtung, versehen sind.

Die hohlzylinderartigen Teilwicklungen können auf einem Tragkörper aufsitzen. Vorzugsweise kann dieser ein zylindrischer oder hohlzylindrischer Tragkörper sein. Dabei korrespondiert ein Querschnitt des Tragkörpers mit einer Hohlzylinderausnehmung der Teilwicklung. Um die Grenzbereiche, d. h., die Bereiche, an welchen die Teilwicklung auf dem Tragkörper aufsitzt zu schirmen, ist es vorgesehen, dass entsprechende Schirmkörper die Grenzbereiche schirmen. So schirmen ringförmige Strukturen den Kontaktierungsbereich von Teilwicklung und Tragelement und glätten dielektrisch. Bei der Gestaltung dieser Schirmkörper können die gleichen Konstruktionsprinzipien zur Anwendung gelangen wie bezüglich der Schirmkörper oben stehend beschrieben.

Eine weitere vorteilhafte Ausgestaltung kann vorsehen, dass die erste, zweite, dritte und vierte Teilwicklung sich um dieselbe Wickelachse erstrecken und axial versetzt zueinander sind, wobei zueinander benachbarte Teilwicklungen jeweils einen verschiedenen Wickelsinn aufweisen.

Ein wechselweises Anordnen von Teilwicklungen, die jeweils unterschiedliche Wickelsinne aufweisen, weist bei einem Vorsehen von einer größeren Anzahl von Teilwicklungen einer Spule den Vorteil auf, dass die Induktivität der Spule vergrößert werden kann, ohne die radiale Ausdehnung der Drosselanordnung zu vergrößern.

Weiter kann vorteilhaft vorgesehen sein, dass die erste, zweite, dritte und vierte Teilwicklung sich um dieselbe Wickelachse erstrecken und axial versetzt zueinander sind, wobei die axial außen liegenden Teilwicklungen jeweils denselben Wickelsinn aufweisen.

Bei einer axialen Beabstandung der Teilwicklungen entlang ihrer Wickelachsen, ist es vorteilhaft, die axial außen liegenden Teilwicklungen mit demselben Wickelsinn auszuführen. Zu einem zentralen Bereich der Spule hin, können sich dann wechselweise Teilwicklungen mit unterschiedlichem Wickelsinn anschließen. Dadurch entsteht ausgehend von dem zentralen Bereich eine symmetrische Spulenanordnung.

Um die Teilwicklungen an ihren endseitigen Spulenanschlüssen (Leiterenden) zu kontaktieren, kann es vorteilhaft vorgesehen sein, dass zueinander benachbarte Teilwicklungen jeweils an ihrem äußeren Umfang oder an ihren inneren Mantelflächen elektrisch miteinander verschaltet werden, so dass eine Spule entsteht. Typischerweise werden die Teilwicklungen auf einem Wickeldorn aufgewickelt, wobei eine Wicklung jeweils mit unterschiedlichem Richtungssinn erfolgt. Ein zweites Leiterende der Teilwicklungen liegt somit radial im inneren Bereich der Teilwicklungen. Ein erstes Leiterende der Teilwicklungen liegt nach erfolgtem Wickeln der jeweiligen Teilwicklung radial am äußeren Umfang der Teilwicklung. Um miteinander benachbarte Teilwicklungen elektrisch zu verschalten, ist es vorteilhaft, jeweils wechselweise eine elektrische Kontaktierung im Bereich des äußeren Umfanges, beispielsweise über eine Brücke, welche den elektrischen Leiter führt und diesen auch dielektrisch schirmt, vorzusehen. Weiter kann vorgesehen sein, dass eine darauf folgend benachbarte Teilwicklung im radial innen liegenden Bereich kontaktiert wird, so dass ein wechselweises Kontaktieren benachbarter Teilwicklungen am äußeren Umfang sowie an der inneren Mantelfläche der Teilwicklung vorgenommen wird. An der inneren Mantelfläche ist es vorteilhaft, wenn der Leiterzug in der Nähe des Tragelementes geführt ist. Dabei kann vorgesehen sein, dass der Leiterzug sich zumindest teilweise im Inneren des Tragelementes erstreckt.

Eine weitere vorteilhafte Ausgestaltung kann vorsehen, dass die Spule eine geradzahlige Anzahl von Teilwicklungen aufweist.

Eine geradzahlige Anzahl von Teilwicklungen gestattet es, eine Spule modular aufzubauen, wobei die einzelnen Module beispielsweise paarige Teilwicklungen aufweisen, die jeweils unterschiedliche Wickelsinne aufweisen. Somit ist es möglich, aus einer Anzahl von paarigen Modulen eine beliebige Spule zusammenzustellen, welche eine anpassbare Induktivität aufweist. Dabei kann je nach Bedarf in leichter Weise durch Abwandlung der Anzahl der verwandten Module eine Spule mit verschiedensten Induktivitäten ausgestattet werden. So kann vorgesehen sein, dass paarige Module jeweils in separaten, ggf. gekapselten Gehäusen angeordnet sind, wobei zur Herstellung einer Spule mehrere Gehäuse miteinander verflanscht werden und die Module miteinander kontaktiert werden.

Vorteilhafterweise kann weiter vorgesehen sein, dass zumindest eine Teilwicklung von einem Medium umgeben ist, welches von einem die anderen Teilwicklungen umgebenden Medium separiert ist.

Um die Spule vor äußeren Einwirkungen zu schützen ist es vorgesehen, dass die Teilwicklungen im Innern eines Gehäuses angeordnet sind. Um die elektrische Stabilität der Spule zu gewährleisten, kann vorgesehen sein, dass das Innere des Gehäuses mit einem Medium, vorzugsweise einem Fluid, befüllt ist. Sieht man nunmehr vor, dass eine oder mehrere Teilwicklungen innerhalb eines Mediums angeordnet sind, welches von einem die anderen Teilwicklungen umgebenden Medium separiert ist, so kann die Betriebssicherheit der Drosselanordnung erhöht werden. Ein gegebenenfalls in einem der Medien auftretender elektrischer Durchschlag wirkt sich nicht unmittelbar auf die von dem anderen Medium umgebenen Teilwicklungen aus. Dabei kann vorgesehen sein, dass die Medien an sich gleichartig sind, beispielsweise können beide Medien als Druckgas ausgestaltet sein. Weiter gestaltet es sich auch bei Wartungsarbeiten vorteilhaft, wenn lediglich eine Teilmenge des Mediums entnommen werden muss, um beispielsweise an einer der Teilwicklungen eine Wartung durchführen zu können.

Im Folgenden wird die Erfindung anhand eines Ausführungsbeispiels in einer Zeichnung schematisch gezeigt und nachfolgend näher beschrieben.

Dabei zeigt die
- Figur 1: eine erste Drosselanordnung mit einer ersten und einer zweiten Teilwicklung, die
- Figur 2: eine zweite Drosselanordnung mit einem ersten Modul von Teilwicklungen sowie einem zweiten Modul von Teilwicklungen und die
- Figur 3: eine dritte Drosselanordnung mit einer alternativen Gehäusegestaltung.

In den Figuren gleichwirkende Elemente werden mit den gleichen Bezugszeichen versehen bzw. sind mit entsprechenden fortlaufenden Indizes versehen.

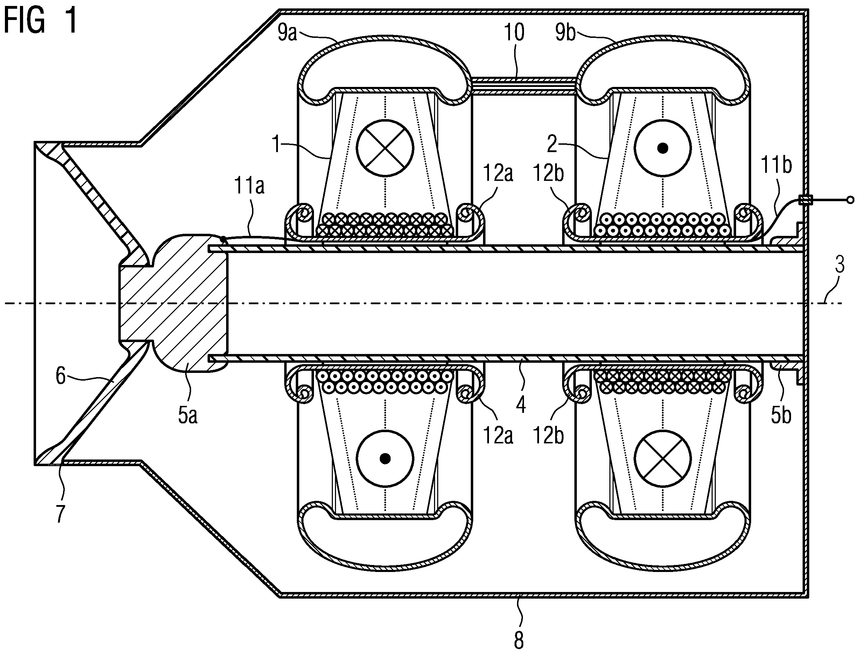

In der Figur 1 ist eine erste Drosselanordnung dargestellt. Die erste Drosselanordnung weist eine erste Teilwicklung 1 sowie eine zweite Teilwicklung 2 auf. Erste und zweite Teilwicklung 1, 2 weisen eine Vielzahl von Windungen auf, welche sich um eine Wickelachse 3 herum erstrecken. Die beiden Teilwicklungen 1, 2 weisen jeweils dieselbe Wickelachse 3 auf. Koaxial zu der Wickelachse 3 ist ein Tragelement 4 angeordnet. Das Tragelement 4 ist als elektrisch isolierendes Rohr ausgestaltet. Als Material zur Ausbildung des Tragelementes 4 sind beispielsweise keramische Werkstoffe, Harze, Faserverbundwerkstoffe, wie beispielsweise glasfaserverstärktes Harz einsetzbar. Das Tragelement 4 ist an seinen axialen Enden jeweils in einer ersten Einspannung 5a sowie einer zweiten Einspannung 5b festgelegt. Die erste Einspannung 5a ist als elektrischer Leiterzug ausgestaltet, welcher eine rotationssymmetrische Struktur aufweist, wobei die Rotationsachse der ersten Einspannung 5a koaxial zur Wickelachse 3 ausgerichtet ist. Die erste Einspannung 5a weist eine ringförmig umlaufende Nut auf, in welche das Tragelement 4 eingeschoben ist. Die zweite Einspannung 5b ist als Flanschsockel ausgeführt, welcher ein Ende des Tragelementes umgreift. Die erste Einspannung 5a ist fluiddicht in einen Isolator 6, beispielsweise ein Schotisolator, ein Scheibenisolator, eine Hochspannungsdurchführung usw. eingesetzt. Der Isolator 6 ist an einem Flansch 7 fluiddicht mit einem metallischen Gehäuse 8 verbunden. Das metallische Gehäuse 8 ist dabei rotationssymmetrisch ausgestaltet und zu der Wickelachse 3 koaxial ausgerichtet. Der von dem Flansch 7 abgewandte Bereich des metallischen Gehäuses 8 ist von dem metallischen Gehäuse scheibenförmig verschlossen. Der scheibenförmige Boden des Gehäuses 8 dient der Halterung der zweiten Einspannung 5b. Das metallische Gehäuse 8 ist fluiddicht ausgeführt. Durch ein fluiddichtes Verschließen des Flansches 7 des metallischen Gehäuses 8 ist das Innere vor einem Eindringen bzw. Austreten von Stoffen durch die von metallischem Gehäuse 8 und weitere Baugruppen gebildete Kapselung verhindert. Dadurch ist es möglich, dass das Innere des metallischen Gehäuses 8 mit einem Fluid zu befüllen. Das Fluid ist beispielsweise ein Isoliergas, welches mit einem erhöhten Druck beaufschlagt ist. So ist es beispielsweise möglich, das Innere mit Schwefelhexafluorid zu fluten und unter einen erhöhten Druck zu setzen. Dadurch ist die Isolationsfestigkeit des Isoliergases zusätzlich erhöht.

Im Innern des metallischen Gehäuses 8 sind die erste Teilwicklung 1 und die zweite Teilwicklung 2 angeordnet. Die Teilwicklungen 1, 2 sind ähnlich aufgebaut. Sie weisen jeweils eine im Wesentlichen hohlzylindrische äußere Gestalt auf, wobei die stirnseitigen Abschnitte der jeweiligen Hohlzylinder mit kegelartigen Anformungen versehen sind. Dadurch ist eine diskusartige Struktur von erster und zweiter Teilwicklung 1, 2 gebildet. Am äußeren Umfang der ersten und der zweiten Teilwicklung 1, 2 ist jeweils ein erster Schirmkörper 9a, 9b angeordnet. Die ersten Schirmkörper 9a, 9b weisen eine ringförmige Struktur auf, welche koaxial zur Wickelachse 3 umlaufend ausgerichtet ist. Die ersten Schirmkörper 9a, 9b weisen jeweils einen elektrisch isolierenden Tragkörper auf, welcher jeweils auf die Teilwicklungen 1, 2 aufgesetzt und mit diesen verspannt ist. Dadurch ist es möglich, dass die ersten Schirmkörper 9a, 9b jeweils auch eine mechanische Stabilisierung der ersten und zweiten Teilwicklung 1, 2 bewirken. Auf den gewölbt umlaufenden Mantelflächen der elektrisch isolierenden Tragkörper der ersten Schirmkörper 9a, 9b ist eine elektrisch leitende Schicht aufgebracht. Diese Schicht ist beispielsweise eine galvanisch aufgebrachte Schicht, eine aufgedampfte Schicht oder ein elektrisch leitender Lack, der in einem Lackier-, Streich-, Tauchverfahren oder anderweitig geeigneten Verfahren auf die elektrisch isolierenden Tragkörper aufgebracht ist. Quer zur Umlaufrichtung der ersten Schirmkörper 9a, 9b sind die elektrisch leitenden Schichten jeweils von einer Unterbrechungsstelle unterbrochen, so dass die elektrisch leitenden Schichten jeweils einen unterbrochenen Ring darstellen. Damit ist verhindert, dass es innerhalb der elektrisch leitenden Schichten der ersten Schirmkörper 9a, 9b zur Ausbildung von Kreisstrombahnen kommt.

Die hohlzylindrische Gestalt der ersten und der zweiten Teilwicklung 1, 2 ist durch ein Wickeln eines elektrisch leitenden Leiters um die Wickelachse 3 herum bestimmt. Dabei wird der elektrisch leitende Leiter in einer Vielzahl von Lagen schraubenförmig um die Wickelachse 3 herum gewunden, wobei eine Vielzahl von Lagen spiralförmig übereinanderliegenden um die Wickelachse 3 herum angeordnet sind. Damit sind jeweils eine Vielzahl von Windungen in der ersten und der zweiten Teilwicklung 1, 2 gebildet. Von der äußeren Erscheinung her sind die beiden Teilwicklungen 1, 2 gleichartig ausgestaltet. Lediglich der Wickelsinn der Windungen der ersten und der zweiten Teilwicklung 1,2 um die Wickelachse 3 herum ist jeweils unterschiedlich gewählt. Der unterschiedliche Wickelsinn ist in der Figur durch die punkt- und kreuzförmigen Symbole in den jeweiligen Hälften bezüglich der Wickelachse 3 symbolisch dargestellt. Des Weiteren sind jeweils die ersten Windungen der ersten sowie der zweiten Teilwicklung 1, 2, welche sich in unmittelbarer Nähe des Tragelements 4 erstrecken, dargestellt. Die weiterhin durch eine Punktierung symbolisierten Lagen von Windungen wurden aus Übersichtlichkeitsgründen nicht dargestellt. Stattdessen wurde ein Kreuz-und ein Punktsymbol zur Symbolisierung des Verlaufes der Windungsrichtungen dargestellt.

Zwischen der ersten und der zweiten Teilwicklung 1, 2 ist eine Brücke 10 angeordnet. Die Brücke 10 ist im Wesentlichen durch einen rohrförmigen Schirmkörper gebildet, welcher eine mechanische Stabilität der Brücke 10 gewährleistet. Im Innern des rohrförmigen Schirmkörpers ist ein elektrischer Leiter geführt, welcher an der ersten und der zweiten Teilwicklung 1, 2 am äußeren Umfang befindliche erste Leiterenden miteinander kontaktiert. Die jeweils am entgegengesetzten Ende der ersten und der zweiten Teilwicklung 1, 2 liegenden zweiten Leiterenden 11a, 11b sind jeweils im Bereich des Tragelementes 4 geführt und dort mit den entsprechenden Anschlusspunkten elektrisch leitend verbunden. Das zweite Leiterende 11a der ersten Teilwicklung 1 ist mit der ersten Einspannung 5a elektrisch leitend kontaktiert. Die erste Einspannung 5a ist fluiddicht durch den Isolator 6 hindurchgeführt, so dass außerhalb des metallischen Gehäuses 8 eine elektrische Kontaktierung der ersten Einspannung 5a und somit der Spule erfolgen kann. Das zweite Leiterende 11b der zweiten Teilwicklung 2 ist elektrisch isoliert und fluiddicht durch das metallische Gehäuse 8 hindurchgeführt, so dass auch dieses zweite Ende außerhalb des metallischen Gehäuses 8 elektrisch kontaktierbar ist. Über die zweiten Enden 11a, 11b der ersten und der zweiten Teilwicklung 1, 2 ist die Spule beispielsweise in einen elektrischen Schwingkreis einkoppelbar.

Der elektrische Leiter der ersten Teilwicklung 1 sowie der elektrische Teilleiter der zweiten Teilwicklung 2 sind jeweils von ein und demselben elektrischen Strom durchflossen. Der elektrische Strom fließt über die zweiten Enden 11a, 11b der ersten und der zweiten Teilwicklung 1, 2 in die Spule hinein bzw. heraus. Aufgrund des unterschiedlichen Wickelsinns der ersten und der zweiten Teilwicklung 1, 2 "umkreist" ein die erste Teilwicklung und die zweite Teilwicklung 1, 2 durchfließender Strom die Wickelachse 3 zwar jeweils, jedoch ist dabei ein unterschiedlicher Richtungssinn des Stromflusses in der ersten Teilwicklung 1 sowie in der zweiten Teilwicklung 2 aufgrund ihrer unterschiedlichen Wicklungssinne gegeben. In der in der Figur 1 dargestellten Schnittebene sind die geschnittenen Windungen der ersten und der zweiten Teilwicklung 1, 2 mit einem Punktsymbol versehen, in welchen ein Strom aus der Zeichenebene heraustreten würde. Entsprechend sind die Abschnitte der Teilwicklungen 1, 2 mit einem Kreuzsymbol versehen, in welchen der Strom in die Zeichenebene eintreten würde.

Die Formgebung der Ausnehmungen der hohlzylindrischen Gestalt von erster Teilwicklung 1 und zweiter Teilwicklung 2 korrespondieren zu dem Querschnitt des Tragelementes 4. Um die Berührungsspalte, welche sich zwischen erster Teilwicklung 1 bzw. zweiter Teilwicklung 2 sowie dem Tragelement 4 ausbilden dielektrisch zu schirmen, sind dort zweite Schirmkörper 12a, 12b angeordnet. Die zweiten Schirmkörper 12a, 12b sind jeweils hohlzylinderartig geformt, wobei deren zentrischer Abschnitt im Bereich des Fügespaltes zwischen erster Teilwicklung und zweiter Teilwicklung 1, 2 eingelegt ist. Die von dem Fügespalt abgewandten Enden der zweiten Schirmkörper 12a, 12b sind jeweils trichterartig erweitert ausgeführt, wobei an ihren Enden toroidartige Ringe positioniert sind.

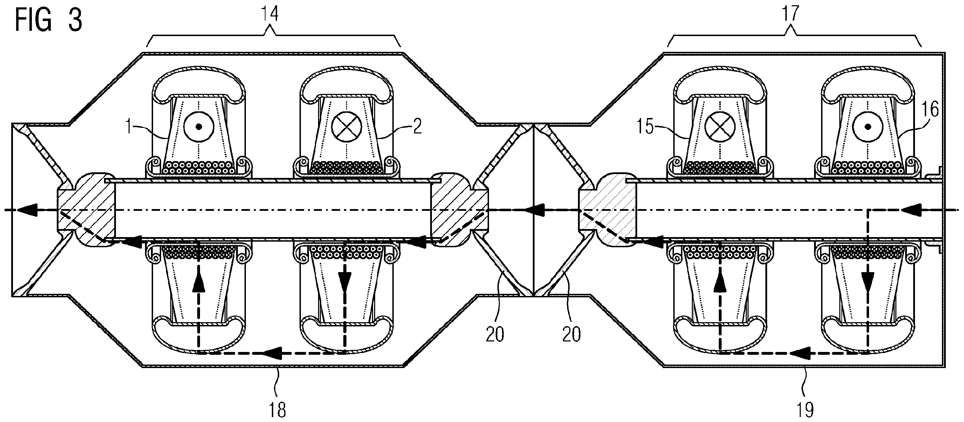

Neben einem scheibenartigen Verschluss des metallischen Gehäuses 8 auf seiner von dem Isolator 6 abgewandten Seite kann auch vorgesehen sein, dass dort ein ähnlicher Scheibenisolator 6 angeordnet ist wie er an dem Flansch 7 des metallischen Gehäuses 8 angeordnet ist. Dadurch ist beispielsweise die Möglichkeit gegeben, das zweite Ende 11b der zweiten Teilwicklung 2 zentrisch aus dem Innern des metallischen Gehäuses 8 nach außen zu führen (vgl. Fig. 3).

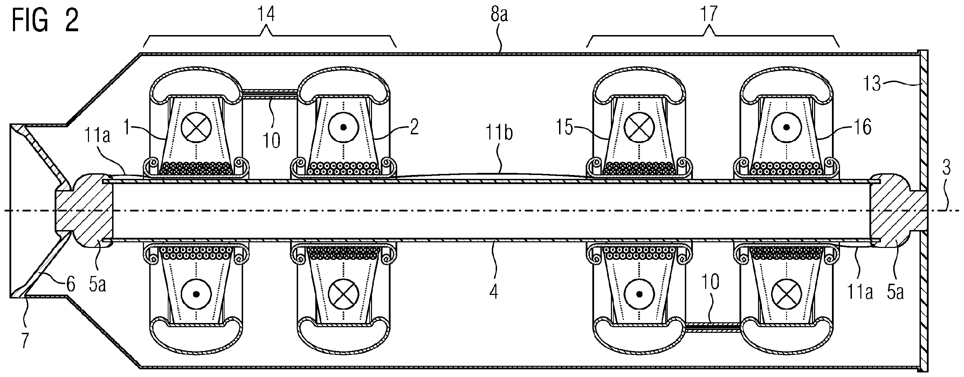

Die Figur 2 zeigt eine Fortbildung der in der Figur 1 gezeigten Anordnung. Dort ist weiterhin ein metallisches Gehäuse 8a vorgesehen, welches sich im Wesentlichen koaxial zu einer Wickelachse 3 erstreckt. An einem ersten stirnseitigen Ende des metallischen Gehäuses 8a ist wiederum ein Isolator 6 angeordnet. Der Isolator 6 verschließt einen Flansch 7 des Gehäuses 8a. An dem entgegengesetzten Ende des metallischen Gehäuses 8a ist eine Isolierplatte 13 vorgesehen. Die Isolierplatte 13 verschließt das metallische Gehäuse 8a fluiddicht. Das Innere des metallischen Gehäuses 8a ist wiederum mit einem unter erhöhten Druck stehenden Isoliergas befüllt. Der Isolator 6 ist von einer ersten Einspannung 5a durchsetzt. Eine weitere erste Einspannung 5a ist baugleich am entgegengesetzten Ende des metallischen Gehäuses 8a in der Isolierplatte 13 gelagert. Zwischen den beiden ersten Einspannungen 5a erstreckt sich ein Tragelement 4. Das Tragelement 4 ist strukturgleich zu dem in der Figur 1 gezeigten Tragelement und unterscheidet sich lediglich in seiner räumlichen Ausdehnung. An dem Tragelement 4 sind eine erste Teilwicklung 1 sowie eine zweite Teilwicklung 2 angeordnet. Die erste Teilwicklung 1 sowie die zweite Teilwicklung 2 bilden ein erstes Modul von Teilwicklungen 14. Weiterhin ist axial versetzt zu dem ersten Modul von Teilwicklungen 14 eine dritte Teilwicklung 15 sowie eine vierte Teilwicklung 16 an dem Tragelement 4 angeordnet. Die dritte Teilwicklung 15 und die vierte Teilwicklung 16 bilden ein zweites Modul von Teilwicklungen 17. Die beiden Module von Teilwicklungen 14, 17 weisen jeweils den gleichen Aufbau auf. Bezüglich der konstruktiven Ausgestaltung der einzelnen Teilwicklungen 1, 2, 15, 16 wird auf die Ausführungen bezüglich der Figur 1 verwiesen. Wie aus der Figur 2 anhand der Kreuz- und Punktsymbole erkennbar ist, sind die jeweils unmittelbar benachbart zueinander angeordneten Teilwicklungen 1, 2, 15, 16 jeweils mit einem unterschiedlichen Wickelsinn ihrer Windungen ausgestattet. Dabei sind die ersten Leiterenden der jeweils zu einem Modul von Teilwicklungen 14, 17 zugehörigen Teilwicklungen 1, 2, 15, 16 jeweils über eine Brücke 10 elektrisch miteinander kontaktiert. Eine Kontaktierung der zweiten Leiterenden 11a, 11b der jeweils endseitig liegenden Abschnitte der Teilwicklungen 1, 2, 15, 16 des ersten Moduls bzw. des zweiten Moduls von Teilwicklungen 14, 15 erfolgt jeweils im Bereich einer Befestigung an dem Tragelement 4. Die zweiten Leiterenden 11a, 11b sind an dem Tragelement 4 geführt und abgestützt. Die Beabstandung der einzelnen Teilwicklungen in axialer Richtung bezogen auf die Wickelachse 3 ist dabei derart gewählt, dass zwischen den zu einem Modul von Teilwicklungen 14, 17 gehörenden Teilwicklungen 1, 2; 15, 16 ein geringerer axialer Versatz vorgesehen ist, als der axiale Versatz zwischen den benachbarten Teilwicklungen 2, 15, die zu unterschiedlichen Modulen von Teilwicklungen 14, 17 gehören. Zueinander benachbarte Teilwicklungen 1, 2, 15, 16 weisen jeweils verschiedene Wickelsinne auf. Es kann auch vorgesehen sein, dass der Abstand zwischen den Modulen von Teilwicklungen 14,17 annähernd dem Abstand der Teilwicklungen 1, 2; 15, 16 innerhalb der Module 14, 17 entspricht.

Die Figur 3 zeigt eine weitere Variante einer Anordnung eines ersten Moduls von Teilwicklungen 14, sowie eines zweiten Moduls von Teilwicklungen 17. Hinsichtlich der Ausgestaltungen der Teilwicklungen 1, 2; 15, 16 der beiden Module von Teilwicklungen 14, 17 wird auf die Ausführungen bezüglich der Figuren 1, 2 verwiesen. Die Figur 3 dient der Verdeutlichung der alternativen Ausgestaltung eines Gehäuses um die Teilwicklungen 1, 2; 15, 16 herum. Bei der Variante gemäß der Figur 3 ist es vorgesehen, dass das erste Modul von Teilwicklungen 14 in einem Isoliermedium befindlich ist, welches von dem das zweite Modul von Teilwicklungen 17 umgebenden Isoliermedium verschieden ist. Jedes der beiden Module von Teilwicklungen 14, 17 ist von einem separaten ersten bzw. zweiten Gehäuse 18, 19 umgeben. Erstes und zweites Gehäuse 18, 19 sind an einander zugewandten Seiten miteinander verflanscht, wobei im Flanschbereich entsprechende Schottisolatoren 20 angeordnet sind, welche ein Übertreten eines Isoliermediums zwischen dem Innern des Gehäuses 18, welches dem ersten Modul von Teilwicklungen 14 zugeordnet ist und dem zweiten Gehäuse 19, welches dem zweiten Modul von Teilwicklungen 17 zugeordnet ist, verhindert. Weiter ist durch die unterbrochene fette Linie ein Stromfluss durch die Teilwicklungen symbolisch dargestellt. Dabei ist erkennbar, dass innerhalb eines Moduls jeweils wechselweise ein Stromfluss von außen nach innen und von innen nach außen, bezogen auf die radiale Lage der Teilwicklungen 1, 2; 15, 16, vorgesehen ist. Die axial außen liegenden Teilwicklungen 1, 16 weisen jeweils den gleichen Wickelsinn auf. Auch hier kann der Abstand zwischen den Modulen von Teilwicklungen 14,17 variiert werden, so, dass er annähernd dem Abstand der Teilwicklungen 1, 2; 15, 16 innerhalb der Module 14, 17 entspricht und alle unmittelbar benachbarten Teilwicklungen 1, 2; 15, 16 etwa den gleichen Abstand voneinander aufweisen.

Neben den in den Figuren gezeigten Ausgestaltungsvarianten können alternative Gehäusebauformen, alternative Einspannungen, alternative Isolatoren, alternative Wickelformen, Schirmelektroden usw. Verwendung finden. Dabei sollte unabhängig von der Art und Weise der körperlichen Ausgestaltung eine Verwendung von unterschiedlichen Wickelsinnen für Teilwicklungen einer Spule Gebrauch gemacht werden.

## Patentansprüche

1. Drosselanordnung mit einer eine erste und eine zweite Teilwicklung (1, 2; 15, 16) aufweisenden Spule, wobei die Teilwicklungen (1, 2; 15, 16) sich jeweils um eine Wickelachse (3) herum erstrecken und die erste Teilwicklung (1, 15) einen ersten Wickelsinn und die zweite Teilwicklung (2, 16) einen zweiten Wickelsinn aufweist und erster und zweiter Wickelsinn voneinander verschieden sind,
**dadurch gekennzeichnet, dass**
zumindest eine der Teilwicklungen (1, 2; 15, 16) einen Schirmkörper (9a, 9b, 12a, 12b) aufweist, welcher einen elektrisch isolierenden Tragkörper aufweist, der eine elektrisch leitende Schicht positioniert.

2. Drosselanordnung nach Anspruch 1,
**dadurch gekennzeichnet, dass**
die erste und die zweite Teilwicklung (1, 2; 15, 16) sich um dieselbe Wickelachse (3) erstrecken.

3. Drosselanordnung nach Anspruch 1,
**dadurch gekennzeichnet, dass**
die elektrisch leitende Schicht auf dem Tragkörper ringförmig umläuft, wobei eine Unterbrechungsstelle einen geschlossenen Umlauf unterbricht.

4. Drosselanordnung nach einem der Ansprüche 1 bis 3,
**dadurch gekennzeichnet, dass**
die Spule eine dritte und vierte Teilwicklung (1, 2; 15, 16) aufweist, wobei eine erste Gruppe von Teilwicklungen den ersten Wickelsinn und eine zweite Gruppe von Teilwicklungen den zweiten Wickelsinn aufweisen.

5. Drosselanordnung nach Anspruch 4,
**dadurch gekennzeichnet, dass**
die erste, zweite, dritte und vierte Teilwicklung (1, 2; 15, 16) sich um dieselbe Wickelachse (3) erstrecken und axial versetzt zueinander sind, wobei zueinander benachbarte Teilwicklungen (1, 2; 15, 16) jeweils einen verschiedenen Wickelsinn aufweisen.

6. Drosselanordnung nach Anspruch 4,
**dadurch gekennzeichnet, dass**
die erste, zweite, dritte und vierte Teilwicklung (1, 2; 15, 16) sich um dieselbe Wickelachse (3)erstrecken und axial versetzt zueinander sind, wobei die axial außen liegenden Teilwicklungen (1, 2; 15, 16) jeweils denselben Wickelsinn aufweisen.

7. Drosselanordnung nach einem der Ansprüche 1 bis 6,
**dadurch gekennzeichnet, dass**
die Spule eine geradzahlige Anzahl von Teilwicklungen (1, 2; 15, 16) aufweist.

8. Drosselanordnung nach einem der Ansprüche 1 bis 7,
**dadurch gekennzeichnet, dass**
zumindest eine Teilwicklung (1, 2) von einem Medium umgeben ist, welches von einem die anderen Teilwicklungen (15, 16) umgebenden Medium separiert ist.

## Claims

1. Choke arrangement comprising a coil having a first and a second partial winding (1, 2; 15, 16), wherein the partial windings (1, 2; 15, 16) each extend around a winding axis (3) and the first partial winding (1, 15) has a first winding sense and the second partial winding (2, 16) has a second winding sense, and the first and the second winding sense are different from one another, **characterized in that** at least one of the partial windings (1, 2; 15, 16) has a shielding body (9a, 9b, 12a, 12b) which has an electrically insulating carrier body which positions an electrically conductive layer.

2. Choke arrangement according to Claim 1, **characterized in that** the first and the second partial winding (1, 2; 15, 16) extend around the same winding axis (3).

3. Choke arrangement according to Claim 1, **characterized in that** the electrically conductive layer runs around on the carrier body in the form of a ring, wherein an interruption point interrupts a closed circulatory path.

4. Choke arrangement according to one of Claims 1 to 3, **characterized in that** the coil has a third and a fourth partial winding (1, 2; 15, 16), wherein a first group of partial windings has the first winding sense and a second group of partial windings has the second winding sense.

5. Choke arrangement according to Claim 4, **characterized in that** the first, second, third and fourth partial windings (1, 2; 15, 16) extend around the same winding axis (3) and are axially offset in relation to one another, wherein partial windings (1, 2; 15, 16) which are adjacent to one another each have a different winding sense.

6. Choke arrangement according to Claim 4, **characterized in that** the first, second, third and fourth partial windings (1, 2; 15, 16) extend around the same winding axis (3) and are axially offset in relation to one another, wherein the axially outer partial windings (1, 2; 15, 16) each have the same winding sense.

7. Choke arrangement according to one of Claims 1 to 6, **characterized in that** the coil has an even number of partial windings (1, 2; 15, 16).

8. Choke arrangement according to one of Claims 1 to 7, **characterized in that** at least one partial winding (1, 2) is surrounded by a medium which is separated from a medium which surrounds the other partial windings (15, 16).

## Revendications

1. Agencement de bobine de self comprenant une bobine ayant un premier et un deuxième sous-enroulement (1, 2 ; 15, 16), les sous-enroulements (1, 2 ; 15, 16) s'étendant respectivement autour d'un axe (3) d'enroulement et le premier sous-enroulement (1, 15) a un premier sens d'enroulement et le deuxième sous-enroulement (2, 16) a un deuxième sens d'enroulement et le premier et le deuxième sens d'enroulement sont différents l'un de l'autre,
**caractérisé en ce que**
au moins l'un des sous-enroulements (1, 2 ; 15, 16) a une pièce (9a, 9b, 12a, 12b) de blindage, qui a une pièce porteuse isolante électriquement, laquelle met en position une couche conductrice de l'électricité.

2. Agence de bobine de self suivant la revendication 1,
**caractérisé en ce que**
le premier et le deuxième sous-enroulements (1, 2 ; 15, 16) s'étendent autour du même axe (3) d'enroulement.

3. Agence de bobine de self suivant la revendication 1,
**caractérisé en ce que**
la couche conductrice de l'électricité entoure annulairement la pièce porteuse, un point d'interruption interrompant un pourtour fermé.

4. Agence de bobine de self suivant l'une des revendications 1 à 3,
**caractérisé en ce que**
la bobine a un troisième et un quatrième sous-enroulements (1, 2 ; 15, 16), un premier groupe de sous-enroulements ayant le premier sens d'enroulement et un deuxième groupe de sous-enroulements le deuxième sens d'enroulement.

5. Agence de bobine de self suivant la revendication 4,
**caractérisé en ce que**
les premier, deuxième, troisième et quatrième sous-enroulements (1, 2 ; 15, 16) s'étendent autour du même axe (3) d'enroulement et sont décalés axialement les uns des autres, des sous-enroulements (1, 2 ; 15, 16) voisins ayant un sens d'enroulement différent.

6. Agence de bobine de self suivant la revendication 4,
**caractérisé en ce que**
les premier, deuxième, troisième et quatrième sous-enroulements (1, 2 ; 15, 16) s'étendent autour du même axe (3) d'enroulement et sont décalés axialement les uns des autres, des sous-enroulements (1, 2 ; 15, 16), à l'extérieur axialement, ayant le même sens d'enroulement.

7. Agence de bobine de self suivant l'une des revendications 1 à 6,
**caractérisé en ce que**
la bobine a un nombre pair de sous-enroulements (1, 2 ; 15, 16).

8. Agence de bobine de self suivant l'une des revendications 1 à 7,
**caractérisé en ce qu'**
au moins un sous-enroulement (1, 2) est entouré d'un milieu, qui est séparé d'un milieu entourant les autres sous-enroulements (15, 16).
